# EUROPEAN PATENT APPLICATION

(11) **EP 2 184 775 A1**
(43) Date of publication of application: **12.05.2010**
(21) Application number: 08792454.4
(22) Date of filing: 14.08.2008
(51) Int. Cl.: H01L 21/76, H01L 21/312, H01L 21/3205, H01L 21/768, H01L 21/8238, H01L 27/08, H01L 27/092

(54) **SEMICONDUCTOR DEVICE, AND ITS MANUFACTURING METHOD**

(30) Priority: 16.08.2007 JP 2007212505
(71) Applicant: National University Corporation Tohoku University, Sendai-shi Miyagi 980-8577 (JP); Tokyo Electron Limited, Tokyo 107-6325 (JP); Ube Industries, Ltd., Ube-shi Yamaguchi 755-8633 (JP); UBE Nitto Kasei Co., Ltd., Tokyo 103-0004 (JP)
(72) Inventor: OHMI, Tadahiro, Sendai-shi Miyagi 980-8577 (JP); MATSUOKA, Takaaki, Tokyo 107-6325 (JP); INOKUCHI, Atsutoshi, Tokyo 107-6325 (JP); WATANUKI, Kohei, Tokyo 105-8449 (JP); KOIKE, Tadashi, Tokyo 103-0004 (JP); ADACHI, Tatsuhiko, Tokyo 103-0004 (JP)
(74) Representative: Goddar, Heinz J.
(86) International application number: PCT/JP2008/064573
(87) International publication number: WO 2009/022719

(57) **Abstract**

In manufacturing processes of a semiconductor device including a shallow trench element isolation region and an interlayer insulating film of a multilayer structure, it is necessary to repeatedly use CMP, but since the CMP itself is costly, the repeated use of the CMP is a cause to increase the manufacturing cost.

As an insulating film for use in a shallow trench (ST) element isolation region and/or a lowermost-layer interlayer insulating film, use is made of an insulating coating film that can be coated by spin coating. The insulating coating film has a composition expressed by ((CH₃)ₙSiO_{2-n/2})ₓ(SiO₂)₁₋ₓ (where n=1 to 3 and 0≤x≤1.0) and a film with a different relative permittivity k is formed by selecting heat treatment conditions. The STI element isolation region can be formed by modifying the insulating coating film completely to a SiO₂ film, while the interlayer insulating film with a small relative permittivity k can be formed by converting it to a state not completely modified.

## Description

### Technical Field

This invention relates to a semiconductor device and its manufacturing method and, in particular, relates to a semiconductor device having one or both of a shallow trench isolation (hereinafter abbreviated as STI) structure and an interlayer insulating film structure and to its manufacturing method.

### Background Art

A semiconductor device having an STI structure is configured such that an element isolation region made of an insulating film is formed in a shallow trench (shallow trench) provided on a surface of a semiconductor substrate and semiconductor elements are formed in a plurality of element forming regions isolated from each other by the element isolation region. On the other hand, a semiconductor device having an interlayer insulating film structure is configured such that at least one interlayer insulating film is provided over a surface of a semiconductor substrate and an element isolation region, an electrode layer is formed to penetrate the interlayer insulating film so as to be electrically connected to at least one of a plurality of regions forming each of semiconductor elements, and a wiring layer is formed on the interlayer insulating film so as to be electrically connected to the electrode layer. In general, a normal semiconductor LSI has both of these two structures.

Both structures are common in that a CMP (chemical-mechanical polishing) process is required. That is, in order to form each of the structures, it is essential to perform the CMP process in the manufacture of conventional semiconductor devices. In the formation of the STI structure, the insulating film is formed on the semiconductor substrate including the shallow trench and, since unevenness of the trench appears on a surface of the insulating film, a technique is employed that flattens the surface of the insulating film by CMP to cause the insulating film to remain only in the shallow trench, thereby forming the element isolation region. On the other hand, the interlayer insulating film is often formed by CVD using BPSG (boro-phospho-silicate glass) as a material thereof. In this case, since unevenness of the surface of the semiconductor substrate before the CVD formation (e.g. due to the protrusion of gate electrode portions) appears on a surface of the BPSG film, it is necessary, after forming the BPSG film, to polish its surface by CMP to flatten it. After flattening it, the formation of the penetrating electrode layer and the formation of the wiring layer on the interlayer insulating film are carried out as described above. Further, when a second-layer interlayer insulating film is provided over such an interlayer insulating film, its surface is also flattened by CMP.

In the case of the semiconductor device having the STI structure and the interlayer insulating film structure, it is necessary to repeat CMP a number of times. Since the CMP process itself is a costly process as compared with etching or the like, the repetition of CMP is a cause to increase the cost of semiconductor devices to be manufactured.

Further, when BPSG forming the interlayer insulating film is polished by CMP, since there is no stopper for the BPSG, there is a possibility that the BPSG is excessively polished to damage gate electrodes. Therefore, it is necessary to carry out the CMP in a state with an extra margin and thus there is a drawback that the thickness of the BPSG should be large.

Patent Document 1 discloses, as a process of burying an STI trench with an insulating film, a process that coats a solution of polysilazane or the like on a silicon substrate to bury an STI trench with the solution and then converts the solution to a SiO₂ film for element isolation by a high-temperature treatment (Patent Document 1, paragraph 0009).

Patent Document 2 discloses, as a substitute process for a BPSG process, a process that cures a spin-on-glass film containing polysilazane by the use of an oxidant solution and then converts it to a silicon oxide film by a heat treatment, thereby forming the silicon oxide film. In order to improve the flatness of a surface of the formed silicon oxide film, Patent Document 2 also discloses that further processing such as a CMP process, a dry etching process, or a wet etching process is applied to the silicon oxide film.

- Patent Document 1:: JP-A-2005-285818
- Patent Document 2:: JP-A-2005-45230

### Disclosure of the Invention

### Problem to be Solved by the Invention

According to Patent Document 1, by the use of the coating film using polysilazane as its material, even if the aspect ratio of the shallow trench is high, the shallow trench can be uniformly buried (Patent Document 1, paragraph 0048). However, Patent Document 1 points out that a CMP process for surface polishing is essential for leaving the element isolation region in the shallow trench. In other words, Patent Document 1 does not point out the problem followed by the CMP process.

Patent Document 2 discloses forming the insulating coating film in the form of the spin-on-glass film containing polysilazane by the coating formation. However, the spin-on-glass film shown in Patent Document 2 has a large number of voids and thus cannot be used as it is, and hence, further processing is essential for improving the flatness. Therefore, various processes are required to increase the cost.

Further, Patent Documents 1 and 2 each only disclose converting the insulating coating film completely to the silicon oxide film, but fail to pay attention to reducing the permittivity of the interlayer insulating film. Further, neither of them suggests anything about producing films with mutually different properties from a single insulating coating film.

Therefore, it is a technical object of this invention to provide a semiconductor device that makes it possible to form an element isolation region and/or an interlayer insulating film without performing CMP, and a method of manufacturing the semiconductor device.

It is a further technical object of this invention to provide a semiconductor device that makes it possible to reduce the manufacturing cost, and a method of manufacturing the semiconductor device.

It is another technical object of this invention to provide a semiconductor device in which an interlayer insulating film having a low permittivity is formed without CMP, and a method of manufacturing the semiconductor device.

It is still another technical object of this invention to provide a semiconductor device in which an element isolation region and an interlayer insulating film having mutually different permittivities are formed from the same composition, and a method of manufacturing the semiconductor device.

### Means for Solving the Problem

According to the invention, therei obtained a semiconductor device comprising an element isolation region, wherein :said element isolation region includes an insulating film made of SiO₂ obtained by modifying, by a heat treatment, a coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0).

Moreove, in accordance with the present invention, there is obtained a semiconductor device, wherein said insulating film has a surface flatness of 0.27µm or less in Ra and 2.6µm or less in P-V (peak-to-valley) value.

Further, in accordance with the present invention, there is obtained a semiconductor device, wherein said element isolation region has a depth of 0.26µm or less and a width of 0.22µm or less.

According to the invention, there is obtained a semiconductor device, wherein said insulating film has a flatness of a degree that does not require CMP.

According to the invention, there is obtained a method of manufacturing a semiconductor device comprising an element isolation region, said method comprising: a step of forming a shallow trench on a semiconductor substrate for forming said element isolation region, a step of coating a coating film on said semiconductor substrate including said shallow trench, anda step of modifying said coating film to an element isolation insulator, wherein said coating film comprises one kind or two or more kinds of compositions expressed by a general formula of ((CH₃)ₙSiO_{2-n/2})ₓ(SiO₂)₁₋ₓ (where n=1 to 3 and 0≤x≤1.0), and said step of modifying is a step of modifying said coating film to a SiO₂ film by a heat treatment.

According to the invention, there is obtained a method of manufacturing a semiconductor device, wherein said heat treatment is performed at a temperature of 800 to 900ºC.

According to the invention there is obtained a method of manufacturing a semiconductor device, said method further comprising a step of causing a surface of said modified SiO₂ film to be equal in height to a surface of said semiconductor substrate without performing CMP.

According to the invention, there is provided a method of manufacturing a semiconductor device, wherein said step of causing a surface of said modified SiO₂ film to be equal in height to a surface of said semiconductor substrate is an etching step.

According to the invention, there is obtained a method of manufacturing a semiconductor device, said method further comprising a step of forming an interlayer insulating film, wherein said step of forming an interlayer insulating film comprises a step of coating a coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0) and a step of heat-treating said coating film at a temperature equal to or less than the temperature in said step of modifying.

According to the invention, there is obtained a method of manufacturing a semiconductor device, wherein the temperature equal to or less than the temperature in said step of modifying is a temperature of 600ºC or less.

According to the invention, there is obtained a method of manufacturing a semiconductor device, wherein the temperature equal to or less than the temperature in said step of modifying is a temperature of 400ºC or less.

According to the invention, there is obtained a method of manufacturing a semiconductor device, wherein said step of forming an interlayer insulating film is performed after a step of forming a source region and a drain region in an element forming region of said semiconductor substrate defined by said element isolation region and a step of forming a gate electrode on said element forming region through a gate insulating film and comprises said step of coating a coating film so as to bury said gate electrode.

According to the invention, there is obtained a method of manufacturing a semiconductor device, said method comprising, after said step of forming an interlayer insulating film, a step of forming an electrode reaching at least one of said source region and said drain region, said electrode penetrating said interlayer insulating film.

According to the invention, there is obtained a semiconductor device comprising an interlayer insulating film of a multilayer structure, said semiconductor device wherein a lowermost layer of said interlayer insulating film includes a coating film expressed by a general formula of ((CH₃)ₙSiO_{2-n/2})ₓ(Si2₎₁₋ₓ (where n=1 to 3 and 0≤x≤1.0).

According to the invention, there is obtained a semiconductor device, wherein an interlayer insulating film as said lowermost layer is an insulating film burying therein a gate electrode of said semiconductor device.

According to the invention, there is obtained a semiconductor device, wherein an electrode reaching at least one of a source region and a drain region of a semiconductor substrate is provided so as to penetrate said interlayer insulating film as said lowermost layer.

According to the invention, there is obtained a semiconductor device, wherein said interlayer insulating film has a permittivity lower than that of SiO₂.

According to the invention, there is obtained a semiconductor device, wherein the permittivity of said interlayer insulating film is 2.0 to 2.7.

According to the invention, there is obtained a semiconductor device, wherein the permittivity of said interlayer insulating film is 2.2 to 2.5.

According to the invention, there is obtained a semiconductor device, wherein an element isolation region formed in a semiconductor substrate is provided under said interlayer insulating film as said lowermost layer and said element isolation region includes a SiO₂ film formed by modifying a coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0).

According to the invention, there is obtained a semiconductor device manufacturing method comprising a step of forming a plurality of semiconductor elements on a semiconductor substrate, a step of forming a first interlayer insulating film on said semiconductor substrate, a step of forming an electrode layer that penetrates said first interlayer insulating film so as to be electrically connected to at least one of a plurality of regions forming each of said semiconductor elements, and a step of forming a first wiring layer on said first interlayer insulating film so as to be electrically connected to said electrode layer, wherein said step of forming a first interlayer insulating film comprises a step of coating a first coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0) and a step of forming a first insulating film having a predetermined permittivity by heat-treating said first coating film at a predetermined temperature.

According to the invention, there is obtained a semiconductor device manufacturing method, wherein said predetermined temperature is a temperature of 400ºC or less.

According to the invention, there is obtained a semiconductor device manufacturing method, wherein said predetermined permittivity is a permittivity lower than that of SiO₂.

According to the invention, there is obtained a semiconductor device manufacturing method, wherein said predetermined permittivity is 2.0 to 2.7.

According to the invention, there is obtained a semiconductor device manufacturing method, wherein said predetermined permittivity is 2.2 to 2.5.

According to the invention, there is obtained a semiconductor device manufacturing method, wherein said plurality of regions forming each of said semiconductor elements include a source region, a drain region, and a gate electrode.

According to the invention, there is obtained a semiconductor device manufacturing method, further comprising a step of forming a second interlayer insulating film on said first interlayer insulating film so as to cover said first wiring layer, a step of forming a first conductor VIA layer that penetrates said second interlayer insulating film so as to be electrically connected to at least part of said first wiring layer, and a step of forming a second wiring layer on said second interlayer insulating film so as to be electrically connected to said first conductor VIA layer.

According to the invention, there is obtained a semiconductor device manufacturing method, wherein said step of forming a second interlayer insulating film comprises a step of coating a second coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0) and a step of forming a second insulating film having a predetermined permittivity by heat-treating said second coating film at a predetermined temperature.

According to the invention, there is obtained a semiconductor device manufacturing method, wherein said step of forming a first wiring layer on said first interlayer insulating film is performed without treating a surface of said first interlayer insulating film by CMP.

According to the invention, there is obtained a semiconductor device manufacturing method according to claim 28, wherein said step of forming a second wiring layer on said second interlayer insulating film is performed without treating a surface of said second interlayer insulating film by CMP.

According to the invention, there is obtained a semiconductor device manufacturing method, wherein a step of forming a shallow trench on said semiconductor substrate, a step of forming an element isolation region in said shallow trench, and a step of forming said plurality of regions forming each of said semiconductor elements are performed before said step of forming a first interlayer insulating film on said semiconductor substrate.

According to the invention, there is obtained a semiconductor device manufacturing method, wherein said step of forming said plurality of regions forming each of said semiconductor elements comprises a step of forming a source region and a drain region in an element forming region of said semiconductor substrate defined by said element isolation region and a step of forming a gate electrode on said element forming region through a gate insulating film.

According to the invention, there is obtained a semiconductor device manufacturing method, wherein said step of forming an element isolation region comprises a step of coating a third coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0) so as to bury at least said shallow trench and a step of modifying said third coating film to SiO₂.

According to the invention, there is obtained a semiconductor device manufacturing method, wherein said step of modifying to SiO₂ comprises a step of baking and annealing said coated third coating film at 800ºC to 900ºC.

According to the invention, there is obtained a method of manufacturing a semiconductor device comprising an element isolation region and an interlayer insulating film, wherein mutually different heat treatments are applied to the same composition, thereby forming said element isolation region and said interlayer insulating film having mutually different permittivities.

According to the invention, there is obtained a method of manufacturing a semiconductor device, wherein said composition comprises one kind or two or more kinds of compositions expressed by a general formula of ((CH₃)ₙSiO_{2-n/2})ₓ(SiO₂)₁₋ₓ (where n=1 to 3 and 0≤x≤1.0).

According to the invention, there is obtained a method of manufacturing a semiconductor device, wherein formation of said element isolation region and said interlayer insulating film includes no CMP process.

According to the invention, there is obtained a semiconductor device comprising a semiconductor substrate, a semiconductor element having a plurality of regions and formed on said semiconductor substrate, a first interlayer insulating film formed on said semiconductor substrate, an electrode layer penetrating said first interlayer insulating film so as to be electrically connected to at least one of said plurality of regions, and a first wiring layer provided on said first interlayer insulating film so as to be electrically connected to said electrode layer, wherein said first interlayer insulating film includes a first coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0).

Preferably, said semiconductor element includes a gate electrode formed on said semiconductor substrate through a gate insulating film and said first interlayer insulating film buries said gate electrode therein.

In a preferred aspect, said plurality of regions include a source region and a drain region and said electrode layer is electrically connected to at least one of said source region and said drain region.

Preferably, said inerlater insulating film has a permittivity lower than that of SiO₂.

### Effect of the Invention

According to a manufacturing method of this invention, it is possible to form an element isolation region and/or an interlayer insulating film without using CMP and thus to reduce the manufacturing cost of a semiconductor device.

According to this invention, it is possible to form insulating films having different permittivities from a single composition by changing the heat treatment temperature and thus to simplify the manufacturing processes.

### Brief Description of the Drawings

Fig. 1 is a sectional view explaining a process of spin-coating an insulating coating film in manufacturing processes of a semiconductor device according to this invention.
Fig. 2 is a diagram for explaining an embodiment 1 of this invention, wherein there is shown a sectional view explaining an STI element isolation region using the insulating coating film shown in Fig. 1.
Fig. 3 is a sectional view explaining manufacturing processes of the semiconductor device including the STI element isolation structure formed according to this invention.
Fig. 4 is a diagram for explaining an embodiment 2 of this invention, wherein there is shown a sectional view explaining a coating process of a lowermost-layer interlayer insulating film carried out after the processes of Fig. 3.
Fig. 5 is a sectional view exemplarily explaining processes carried out after the processes of the embodiment 2 of this invention.
Fig. 6 is a sectional view showing another example of processes carried out after the processes of the embodiment 2 of this invention.
Fig. 7 is a sectional view showing still another example of processes carried out after the processes of the embodiment 2 of this invention.
Fig. 8 is a sectional view showing an example of processes carried out after the processes of the embodiment 2 of this invention, wherein there is shown an example of an interlayer insulating film of a multilayer structure.
Fig. 9 is a sectional view showing another example of processes carried out after the processes of the embodiment 2 of this invention, wherein there is shown another example of an interlayer insulating film of a multilayer structure.
Fig. 10 is a sectional view showing another example of processes carried out after the processes of the embodiment 2 of this invention, wherein there is shown still another example of an interlayer insulating film of a multilayer structure.
Fig. 11 is a schematic diagram showing equipment used in a baking evaluation of an insulating coating film according to this invention.
Fig. 12 is a diagram showing the relationship between the baking temperature and the surface roughness and thickness of the film when baking is carried out using the equipment shown in Fig. 11.
Fig. 13 is a diagram showing the relationship between the rising rate of the baking temperature and the surface roughness of the insulating coating film according to this invention along with images.
Fig. 14 is a diagram showing the relationship between the spin-coating rotation speed and the thickness and relative permittivity k of the insulating coating film according to this invention.
Fig. 15 is a diagram explaining the electrical properties of the insulating coating film according to this invention.

### Best Mode for Carrying Out the Invention

Hereinbelow, embodiments of this invention will be described with reference to the drawings.

### (Embodiment 1)

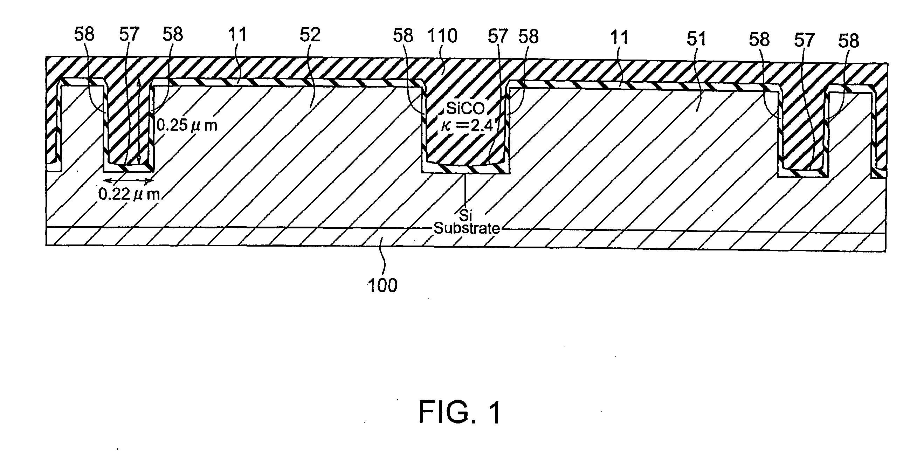

Fig. 1 is a sectional view showing part of manufacturing processes of a semiconductor device using surface-flattened coating films (smoothed films) according to this invention. Specifically, in a silicon substrate 100, there are provided an n-well 51 formed by implanting phosphorus (P) and a p-well 52 formed by implanting boron (B).

Further, a shallow trench (ST) 57 for element isolation is formed on a surface of a boundary portion between the n-well 51 and the p-well 52 and surfaces of the n-well and the p-well. The illustrated shallow trench 57 has a width of 0.22µm and a depth of 0.25µm.

The surfaces of the n-well 51 and the p-well 52 are formed with a SiO₂ film 11 and a bottom surface and side surfaces of the shallow trench 57 are also formed with a SiO₂ film 58.

An insulating coating film 110 according to this invention is coated on the illustrated SiO₂ films 11 and 58. The insulating coating film 110 is formed by coating a material having a composition of (CH₃SiO_{3/2})ₓ(SiO₂)₁₋ₓ (where 0≤x≤1.0).

As is clear from the composition (CH₃SiO_{3/2})ₓ(SiO₂)₁₋ₓ of the insulating coating film 110, the insulating coating film contains Si, C, and O and the ratio of the numbers of these component atoms is O>Si≥C. The insulating coating film 110 contains a methyl group (CH₃) and the methyl group is liberated in air at 480ºC but is not liberated in N₂ even at 600ºC. Herein, if x=1.0, i.e. in a state of only a CH₃SiO_{3/2} component, the relative permittivity k of the insulating coating film is 2.0, if x=0.9, k is 2.1, if x=0.7, k is 2.3, and if x=0.5, k is 2.7. As a coating solution, use is made of one in which 5wt% or more of the above-mentioned composition is dissolved in a solvent and, after coating it, heating is applied under a reduced pressure to completely remove the solvent. If heating is applied at 500ºC under a reduced pressure of 1 to 4Torr, the insulating coating film with k of 2.0 to 2.1 is obtained and, if heating is applied at 400ºC under a reduced pressure of 1 to 5Torr, the insulating coating film with k of 2.3 to 2.7 is obtained. If heating is applied at 800ºC, the methyl group is liberated so that the insulating coating film 110 is modified to SiO₂ and, only with the SiO₂, the relative permittivity k becomes 4.0. The insulating properties of this SiO₂ exhibit excellent values of 1×10⁻¹⁰ (A/cm²) at 1 (MV/cm), 1×10⁻⁹ (A/cm²) at 3 (MV/cm), and 1×10⁻⁸ (A/cm²) even at 5 (MV/cm).

Hereinbelow, the above-mentioned insulating coating film and its composition may be abbreviated as a SiCO film and SiCO, respectively. Since the coating solution forming the insulating coating film (SiCO film) 110 is in a liquid state at ordinary temperature, the insulating coating film 110 can be spin-coated on the semiconductor substrate and has fluidity in a coated state so that it does not reflect unevenness of the bottom surface and thus has high flatness.

Herein, when the insulating coating film 110 is baked and annealed at 900ºC, it is modified to SiO₂ (k=4.0) free of gas generation and thermal contraction and excellent in heat resistance. Therefore, if it is necessary to modify the insulating coating film 110 completely to a SiO₂ film, such complete modification is enabled. Thus, by selecting heat treatment conditions of the insulating coating film 110 formed by the SiCO film, it is possible to form a surface-flattened film having a permittivity in the range of k=2.0 to 4.0.

Referring back to Fig. 1, the insulating coating film 110 is formed by spin-coating SiCO on the silicon substrate 100 and has a relative permittivity of 2.4 in this state. Since the insulating coating film 110 made of SiCO has fluidity upon coating, its surface can be maintained flat without being affected by unevenness on the silicon substrate 100 due to the shallow trench 57, the SiO₂ film 58, and so on.

Then, when etching the surface-flattened film obtained by baking the insulating coating film 110 formed of SiCO, since the surface-flattened film can be clearly distinguished from a silicon nitride film (Si₃N₄), the silicon substrate 100, or the like, it can be etched by providing the silicon nitride film (Si₃N₄) on the SiO₂ film 11 and using it as a stopper or by using the silicon substrate 100 as a stopper. Therefore, the surface-flattened film formed of SiCO can be uniformly removed, while maintaining the flatness of its surface, only by etching without using CMP.

The insulating coating film 110 shown in Fig. 1 is, after the coating, baked and annealed at a temperature of 800ºC to 900ºC. As a result of this heat treatment, the insulating coating film 110 is modified to SiO₂. After the modification, the insulating coating film 110 becomes a SiO₂ film with a flat surface maintained.

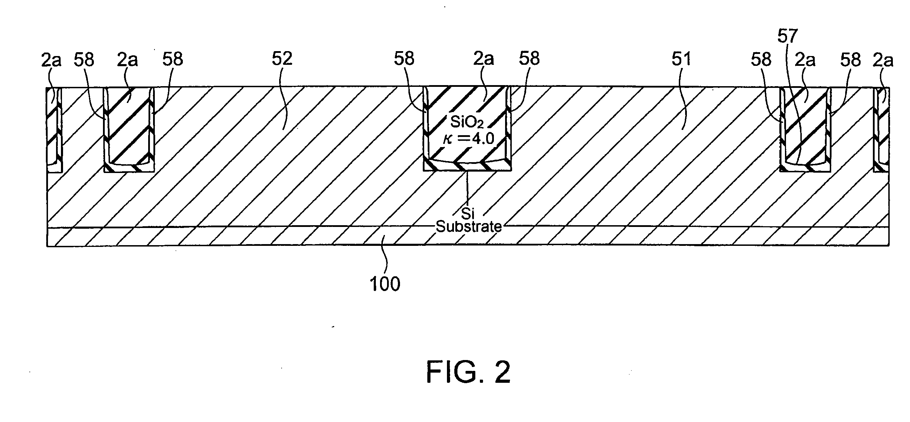

Referring to Fig. 2, there is shown a state where, in the SiO₂ film being the insulating coating film 110 after the modification, the SiO₂ film on the n-well 51 and the p-well 52 of the silicon substrate 100 has been etched.

In this case, an STI element isolation region 2a made of SiO₂ obtained by completely modifying SiCO remains in the shallow trench 57.

As shown in Fig. 2, a surface of the STI isolation region 2a in the shallow trench 57 is flush with the surface of the silicon substrate 100. This is because the SiO₂ film can be etched using the silicon substrate 100 as an etching stopper.

Since the SiCO film according to this invention does not require CMP, not only can it be used as the surface-flattened film having the flat surface, it can also form the STI element isolation region excellent in insulating properties with no voids. The permittivity of the element isolation region 2a is 4.0 equal to that of SiO₂.

As is also clear from Fig. 2, using SiCO according to this invention, it is possible to form the STI element isolation region 2a in the shallow trench 57 without performing CMP.

### (Embodiment 2)

The SiCO film according to this invention can obtain not only the effect of forming the STI isolation region 2a, but also an effect of making CMP unnecessary and achieving a low permittivity when applied to formation of an interlayer insulating film. Hereinbelow, a description will be given, as an embodiment 2, the case where the SiCO film according to this invention is used as a lowermost-layer interlayer insulating film.

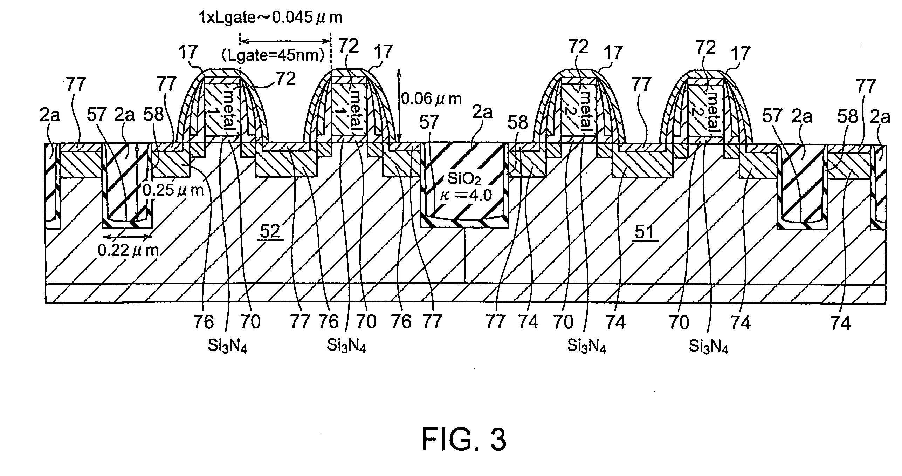

Referring to Fig. 3, a description will be given of manufacturing processes of the semiconductor device carried out after forming the STI element isolation region 2a shown in Fig. 2.

In the structure of Fig. 2 in which the STI element isolation region 2a formed by heat-treating the insulating coating film 110 is buried in the shallow trench 57, respective regions forming semiconductor elements are formed as shown in Fig. 3. Specifically, as shown in Fig. 3, gate insulating films 70 made of silicon nitride (Si₃N₄) are formed on the surfaces of the n-well 51 and the p-well 52 (which are element forming regions, respectively) surrounded by the STI element isolation region 2a and a gate electrode 72 is mounted on each gate insulating film 70. Side surfaces and a surface of each gate electrode 72 and gate insulating film 70 are covered with an oxide film 17.

Further, p-type element regions (source and drain regions) 74 formed by implanting p-type impurities are provided at the surface of the n-well 51, while n-type element regions (source and drain regions) 76 formed by implanting n-type impurities are provided at the surface of the p-well 52. A silicide layer 77 for contact is formed at the surface of each of the element regions (source and drain regions) 74 and 76.

In the illustrated example, the distance between the gate electrodes 72 of two MOS transistors formed on each of the n-well 51 and the p-well 52 is 45nm.

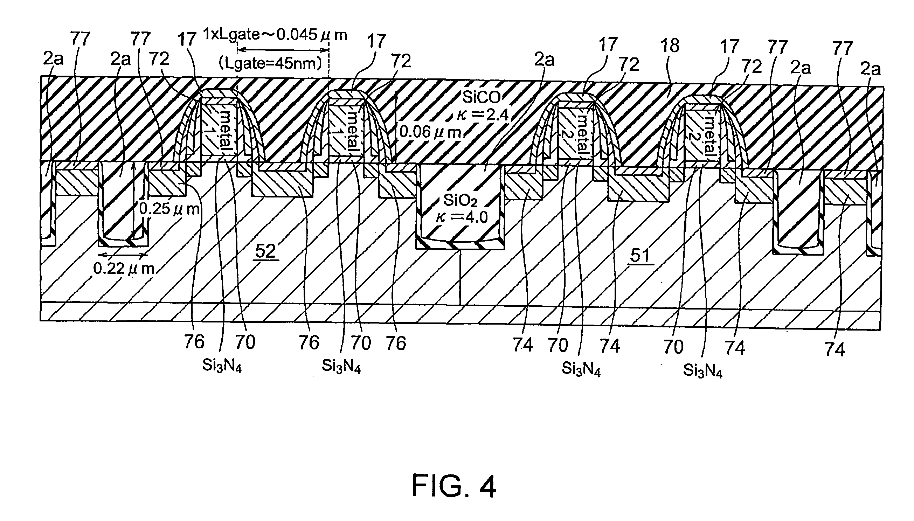

Referring to Fig. 4, an insulating coating film 18 made of SiCO is coated as an interlayer insulating film on the surfaces of the element forming regions of the silicon substrate 100 and the STI element isolation region 2a so as to bury therein the gate electrodes 72 and the oxide films 17 covering the side surfaces and the surfaces of the gate electrodes 72. Herein, it is assumed that the insulating coating film 18 is the same as the SiCO film used for forming the STI isolation region 2a. Therefore, like the above-mentioned SiCO used for forming the STI element isolation region 2a, the coated insulating coating film 18 absorbs unevenness formed due to the protrusion of the gate electrodes to exhibit the surface flatness, has a high insulation resistance, and has an extremely low relative permittivity k of about 2.4 by adjusting the temperature in baking.

Specifically, as shown in Fig. 4, in the embodiment 2 according to this invention, the lowermost-layer interlayer insulating film covering the gate electrodes 72 protruding from the silicon substrate 100 is formed by coating the insulating coating film 18. Since, as described with respect to the STI element isolation region 2a, the insulating coating film 18 formed of SiCO is a coating film having fluidity, even if it is coated on the surface, with the unevenness such as the gate electrodes 72, of the silicon substrate 100, it does not reflect the surface unevenness of the silicon substrate 100 and thus its surface maintains the flatness. Further, when heat-treated at a low temperature of about 400ºC, SiCO of the above-mentioned composition is not modified to a SiO₂ film and thus is in a state containing a large amount of a CH₃SiO_{3/2} component. Therefore, the insulating coating film 18 shown in Fig. 4 has the lower relative permittivity k as compared with the SiO₂ film.

As described above, since the insulating coating film 18 formed of SiCO maintains high flatness, it is not necessary to carry out flattening by CMP. Further, since it is possible to reduce the relative permittivity k of the interlayer insulating film, the high-speed operation of the device is not impaired. By reducing the relative permittivity, it is possible to reduce the parasitic capacitance of the electrodes and wiring and thus to achieve high-speed transmission of signals.

There are a variety of processes after forming the interlayer insulating film 18 shown in Fig. 4 and a semiconductor device manufacturing method according to this invention is applicable to any of them. For example, it may be configured such that the interlayer insulating film 18 is provided with through holes reaching the contact layers 77 of the source/drain regions 74 and 76 and the gate electrodes 72, electrode lead-out conductors electrically connected to the contact layers 77 and the gate electrodes 72, respectively, are provided in the through holes, and wiring layers electrically connected to these conductors are provided on a surface of the interlayer insulating film 18, thereby forming a semiconductor device.

Hereinbelow, processes in the case where a multilayer wiring structure is provided over the interlayer insulating film 18 will be exemplarily described.

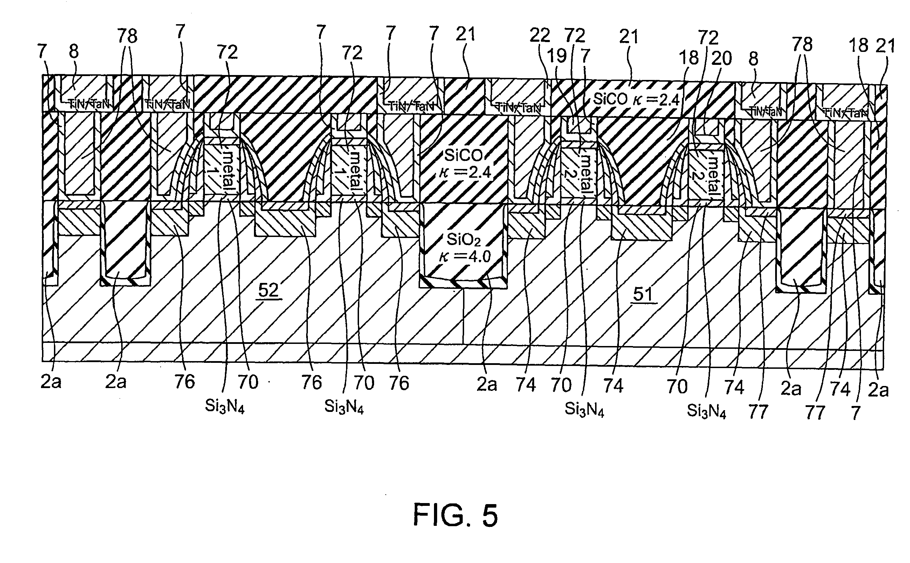

Referring to Fig. 5, a smooth film 21 made of SiCO is further coated as a second-layer interlayer insulating film by spin coating on the interlayer insulating film 18 formed by the above-mentioned technique. The illustrated smooth film 21 is obtained by baking and annealing SiCO at a low temperature of about 400ºC and, as a result, has a relative permittivity k of 2.4. Therefore, also in this example, the relative permittivity k of the interlayer insulating film can be reduced.

In the illustrated example, electrode lead-out conductors 78 to the contact layers 77 and gate wirings 19 to the gate electrodes 72 of the MOS transistors are formed by applying normal techniques such as resist coating, exposure, and etching to the lowermost-layer interlayer insulating film 18 and, further, wirings 8 respectively connected to the source/drain regions of the MOS transistors are buried in via holes of the smooth film 21. As a material of the conductors 78, the gate wirings 19, and the wirings 8, Cu or W can be used. When Cu or W is used, a conductive barrier layer 7 of TiN, TaN, or the like is preferably formed in each via hole as an underlayer for Cu or W.

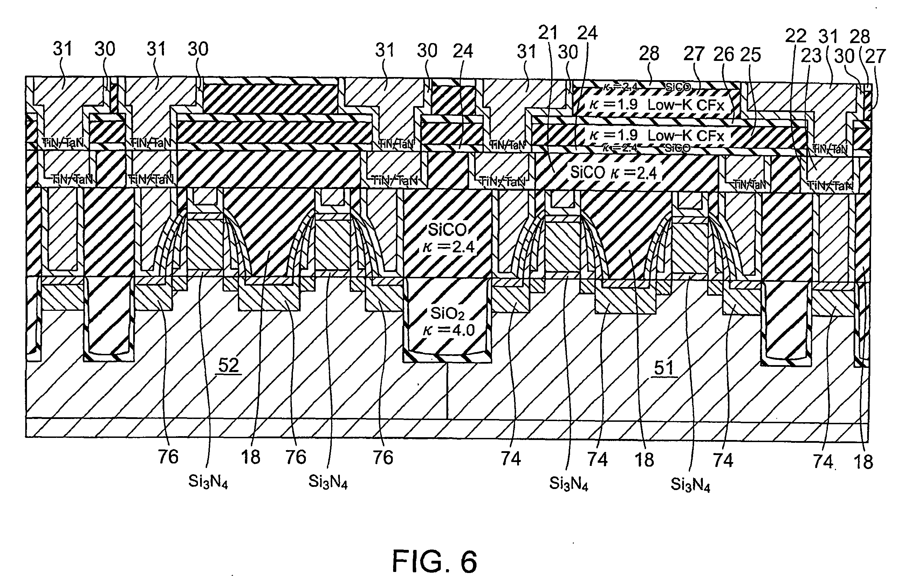

Referring to Fig. 6, there is shown an example in which, after coating a smooth film 21 made of SiCO by spin coating like in Fig. 5 after forming the lowermost-layer interlayer insulating film 18, a multilayer interlayer insulating film is further formed. In the example of Fig. 6, a first barrier layer 24 made of SiCO is formed by CVD on the smooth film 21 being a second-layer interlayer insulating film formed of SiCO and then a fluorocarbon (CFx) film 25 is formed as a third-layer interlayer insulating film. The illustrated CFx film 25 has a relative permittivity k (=1.9) lower than those of the SiCO films 18 and 21 baked at the low temperature.

Further, in the illustrated example, a second SiCO barrier layer 26 is formed by CVD on the CFx film 25 as the third-layer interlayer insulating film and a low relative permittivity CFx film 27 is formed as a fourth interlayer insulating film on the second barrier layer 26. Further, a third SiCO barrier layer 28 is formed by CVD on the CFx film 27. As in this example, by forming the interlayer insulating films using the CFx films each having the relative permittivity k still lower than that of the SiCO film baked at the low temperature, the relative permittivity of the entire multilayer-structure interlayer insulating film can be further reduced.

Also in the example shown in Fig. 6, wirings 31 are formed through the CFx films 25 and 27 forming the third and fourth interlayer insulating films and the first to third CVD insulator barrier layers 24, 26, and 28 and a conductive barrier layer 30 is provided as an underlayer for each wiring 31.

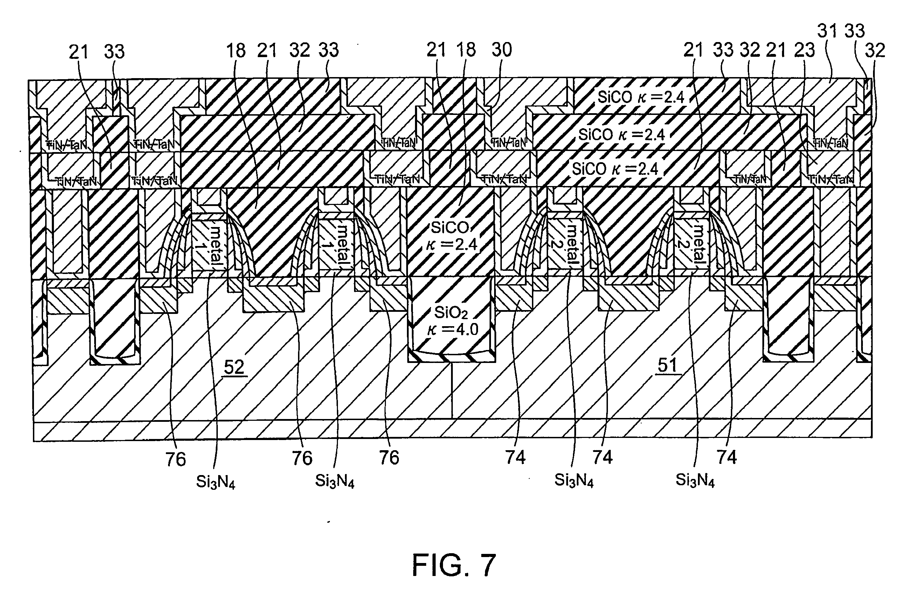

Referring to Fig. 7, there is shown an example in which the lowermost-layer interlayer insulating film 18, an uppermost interlayer insulating film, and intermediate interlayer insulating films are all formed by SiCO coating films. In the illustrated example, a second-layer interlayer insulating film 21, a third-layer interlayer insulating film 32, and a fourth-layer interlayer insulating film 33 are each formed by a SiCO film obtained by coating the above-mentioned SiCO and heat-treating it at a low temperature of 400ºC. In this connection, the second-layer to fourth-layer interlayer insulating films 21, 32, and 33 each have a relative permittivity of 2.4 equal to that of the lowermost-layer interlayer insulating film 18.

Also in the example shown in Fig. 7, like in Fig. 6, there are provided wirings 31 respectively connected to the source/drain regions of the MOS transistors, and barrier layers 30 serving as underlayers for the wirings 31.

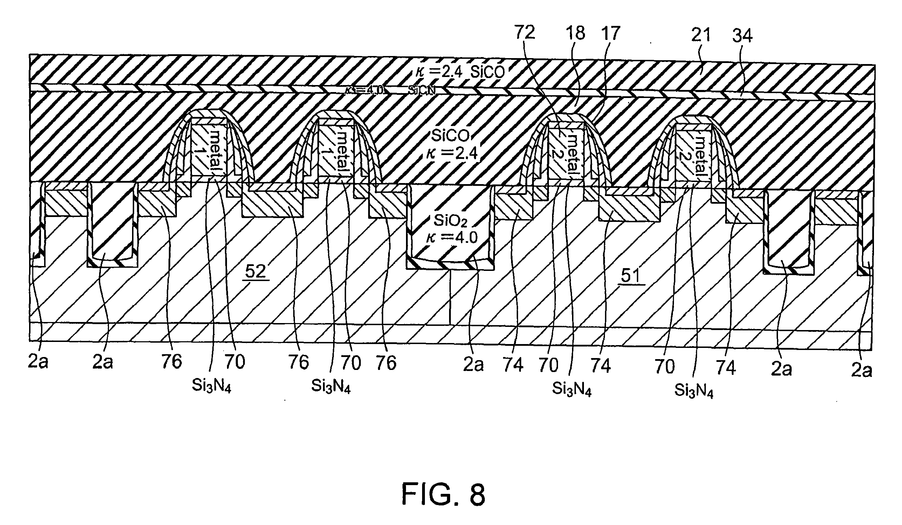

In an example shown in Fig. 8, an insulating barrier layer 34 in the form of a SiCN film is provided on the lowermost-layer interlayer insulating film 18 having a relative permittivity k of 2.4 and a second-layer interlayer insulating film 21 formed by coating SiCO is coated on the insulating barrier layer 34. In this case, the SiCN film 34 is formed by CVD and has a relative permittivity k of 4.0, for example.

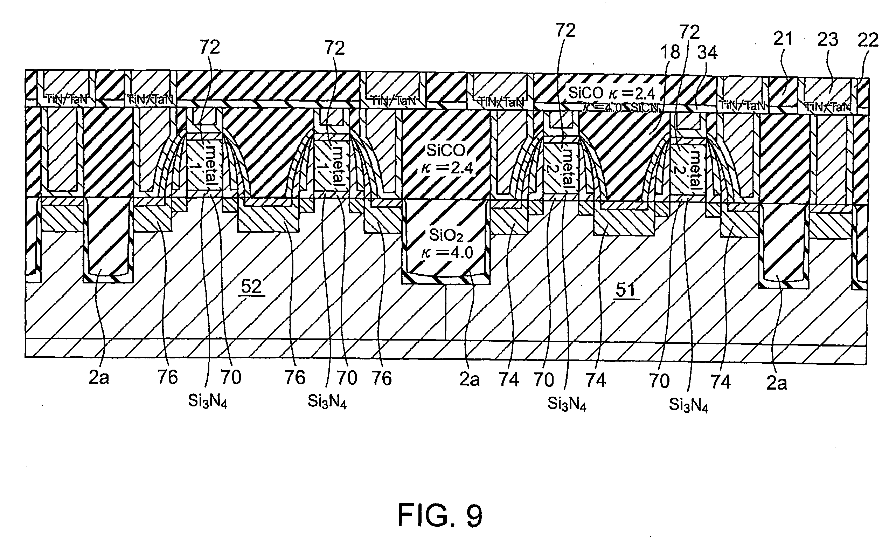

Referring to Fig. 9, there is shown a state where electrodes and wirings are formed in the multilayer-structure interlayer insulating film shown in Fig. 8. Specifically, gate electrode wirings are respectively formed for the gate electrodes 72 of the MOS transistors and, further, via holes penetrating the lowermost-layer interlayer insulating film 18, the SiCN film 34, and the second-layer interlayer insulating film 21 are respectively formed for the source/drain regions of the MOS transistors and, in each via hole, a conductive barrier layer 22 and a wiring 23 are formed.

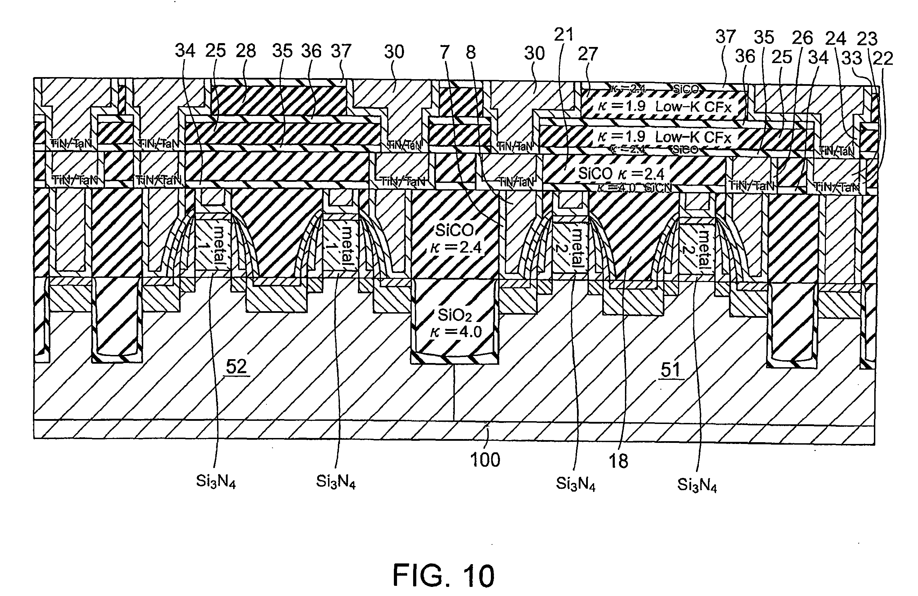

Referring to Fig. 10, over the second-layer interlayer insulating film 21 shown in Fig. 8, third-layer and fourth-layer interlayer insulating films 25 and 27 each in the form of a CFx film are respectively formed on barrier layers 35 and 36 formed of SiCN. Further, a SiCN barrier layer 37 is formed also on the fourth-layer interlayer insulating film 27. In this example, the insulating barrier layers 34, 35, 36, and 37 are formed of SiCN having a relative permittivity k of 4.0, while the interlayer insulating films 18 and 21 are each formed by the SiCO film having a relative permittivity of 2.4 and the interlayer insulating films 25 and 27 are each formed by the CFx film having a relative permittivity k of 1.9.

In each of the examples described above, the lowermost-layer interlayer insulating film 18 is formed by the SiCO coating film that does not require flattening by CMP. Accordingly, it is not necessary to flatten the surface of the lowermost-layer interlayer insulating film 18 by CMP or the like.

Therefore, in the manufacturing method according to this invention, since it is possible to minimize the number of times of using CMP, the cost required for CMP can be reduced. Further, since it is possible to reduce the relative permittivity k of the entire multilayer-structure interlayer insulating film, the stray capacitance and the leakage current can be prevented.

Next, a description will be given of the properties of the SiCO insulating coating film used in this invention.

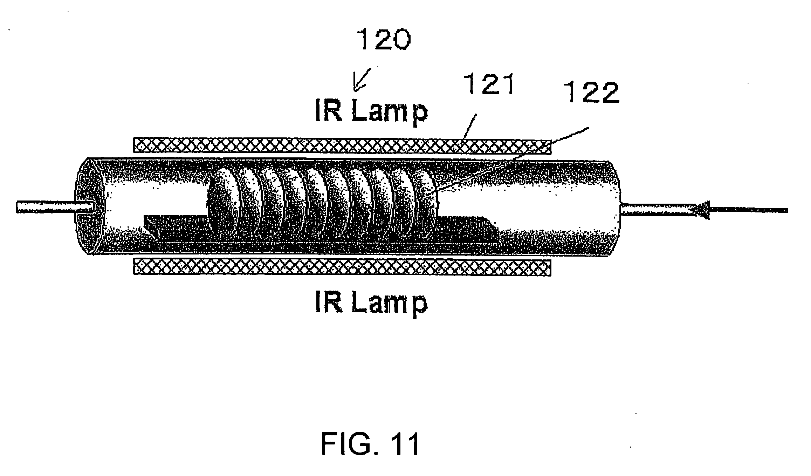

First, referring to Fig. 11, an apparatus used in a baking evaluation test of an insulating coating film will be described. The baking evaluation test was performed using an infrared baking furnace 120. Specifically, baking was carried out by passing a tray with silicon wafer samples 122 placed thereon in the infrared baking furnace 120 provided with IR lamps 121. The baking temperature range was 300°C to 800ºC. The baking was carried out in four kinds of gas atmospheres, i.e. N₂; N₂80%+O₂20%; O₂100%; and O₂100%+H₂O3%. In this case, the gas flow rates were 1 slm (linear velocity: 0.6cm/sec) and 5slm (linear velocity: 3.0cm/sec).

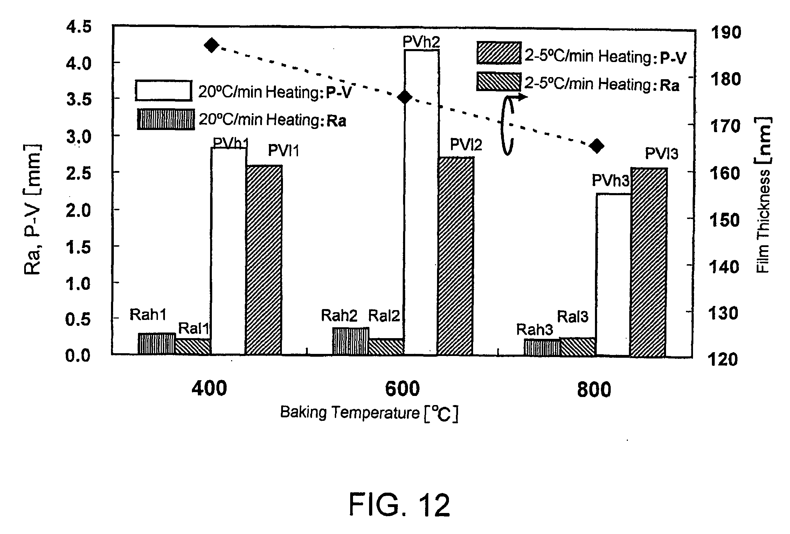

Referring to Fig. 12, there is shown the relationship between the surface roughness (Ra and peak-to-valley (P-V) value) of the insulating coating film according to this invention and the heating profile. Fig. 12 shows the relationship between the surface roughness and the heating rate at 400ºC, 600ºC, and 800ºC. In Fig. 12, the surface roughness when heated to 400ºC at 20ºC/min is given by Ra (Rah1) and a P-V value (PVh1), while the surface roughness when heated to 400ºC at 2 to 5ºC/min is given by Ral1 and PV11.

Further, the surface roughness when heated to 600ºC at 20ºC/min is given by Rah2 and PVh2, while the surface roughness when heated to 600ºC at 2 to 5ºC/min is given by Ral2 and PVI2. Further, the surface roughness when heated to 800ºC at 20ºC/min is given by Rah3 and PVh3, while the surface roughness when heated to 800ºC at 2 to 5ºC/min is given by Ral3 and PVI3.

As is also clear from Fig. 12, it is seen that the surface roughness Ra and P-V value tend to decrease as the heating rate decreases. Therefore, if the insulating coating film is baked at 2 to 5ºC/min, the surface roughness can be made small. Fig. 12 also shows the relationship between the baking temperature and the thickness (right scale) of the insulating coating film, wherein it is seen that the thickness of the insulating coating film tends to decrease as the baking temperature increases.

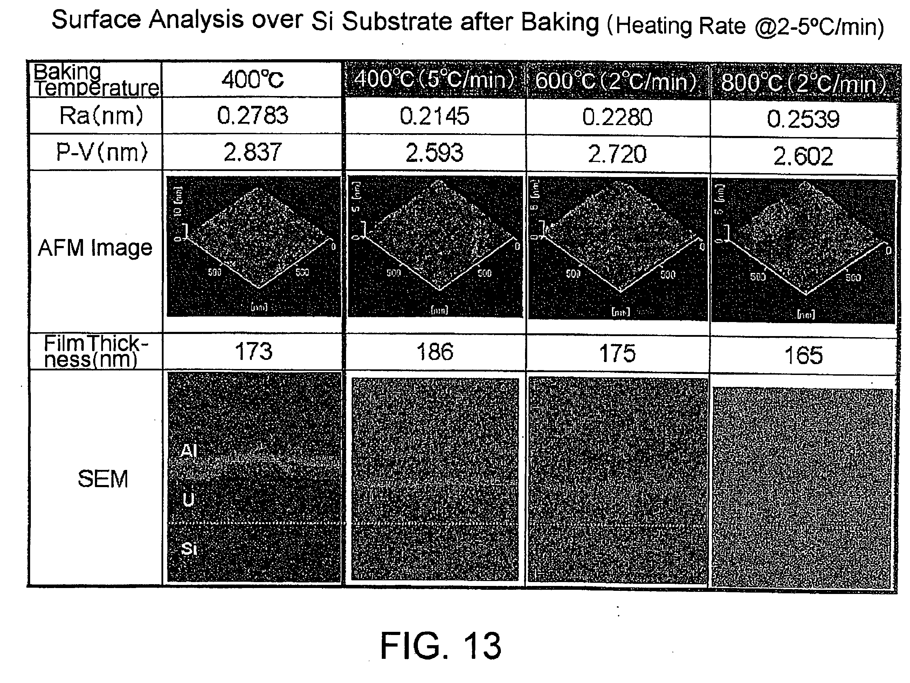

Referring to Fig. 13, the relationship between the baking temperature and the surface roughness (Ra, P-V) is shown along with actual AFM (Atomic Force Microscope) images and SEM (Scanning Electron Microscope) images. As is also clear from the surface roughness (Ra, P-V) and the AFM image, Ra and the P-V value when heated to 400ºC at a heating rate of 20ºC/min are 0.2783nm and 2.837nm, respectively, thus having a surface as shown in the AFM image. Further, as shown in the SEM image, an aluminum film formed on the insulating coating film designated by U has a rough surface.

On the other hand, when the insulating coating film is baked by heating to 400ºC at a heating rate of 5ºC/min, Ra and the P-V value of its surface become 0.2145nm and 2.593nm, respectively, and, as is also clear from the AFM and SEM images, the surface roughness can be made smaller than that when heated at 20ºC/min. Likewise, when the insulating coating film is baked by heating to 600ºC at a heating rate of 2ºC/min, Ra and the P-V value of its surface become 0.2280nm and 2.720nm, respectively, and, when heated to 800ºC at a heating rate of 2ºC/min, Ra and the P-V value become 0.2539nm and 2.602nm, respectively, so that the surface roughness can be improved in both cases as compared with that when heated at 20ºC/min.

From the evaluation results described above, it has been found that the surface smoothness (surface roughness) is improved to Ra=0.27nm or less by reducing the heating rate in baking to 10ºC/min or less (preferably 1 to 5ºC/min).

The baking temperature is set to 300 to 900ºC (preferably 400ºC to 800ºC). The flatness of a surface-flattened film is improved by high-temperature baking (800ºC), but the film thickness tends to decrease.

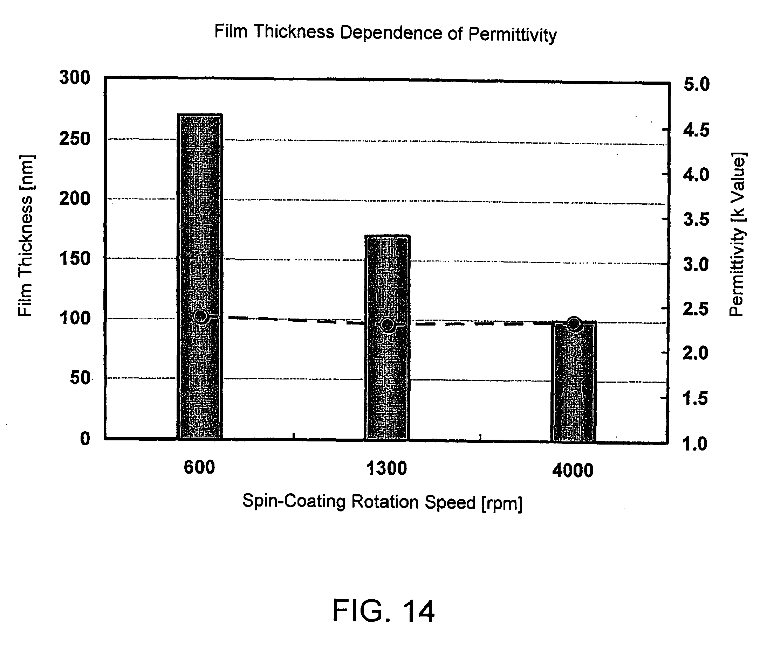

Referring to Fig. 14, the relationship between the thickness of the insulating coating film and the spin-coating rotation speed is shown along with the relationship between the relative permittivity k of the insulating coating film and the spin-coating rotation speed. As shown in Fig. 14, it is seen that the thickness of the insulating coating film decreases from 270nm to 100nm as the spin-coating rotation speed increases from 600rpm to 4000rpm, while the relative permittivity k is substantially constant (2.4) regardless of the spin-coating rotation speed.

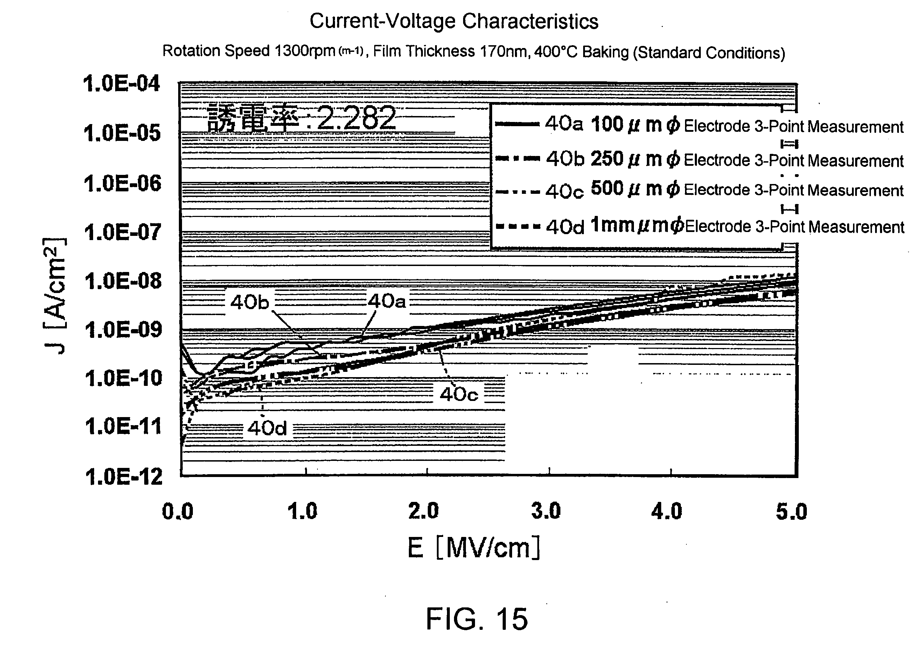

Referring to Fig. 15, there are shown the current-voltage characteristics of a surface-flattened film obtained by baking at 400ºC the insulating coating film coated to a thickness of 170nm at a rotation speed of 1300rpm. As is also clear from Fig. 15, the surface-flattened film according to this invention exhibits a current characteristic of 1.0×10⁻⁸ (A/cm²) or less at a voltage of 4.0 (MV/cm) or less and, as a result of this, it is seen that it has high insulating properties. The relative permittivity k of the surface-flattened film shown in Fig. 15 is 2.282. Likewise, a surface-flattened film obtained by baking at 400ºC the insulating coating film coated to a thickness of 270nm at a rotation speed of 600rpm exhibits similar current-voltage characteristics.

To sum up the electrical properties of the surface-flattened film, there is obtained the dielectric film with no change in permittivity or smoothness even if the thickness is changed and with a voltage resistance of 10 (MV/cm) even if the thickness is reduced (100nm) and it has been found that when the thickness is reduced, current variations occur if the electrode area increases.

In the above-mentioned embodiments, the examples are shown in which use is made of the coating film with the composition of (CH₃SiO_{3/2})ₓ(SiO₂)₁₋ₓ (where 0≤x≤1.0). However, in this formula, instead of CH₃SiO_{3/2}, use may be made of, for example, (CH₃)₂SiO, (CH₃)₃SiO_{1/2}, or the like, or a mixture thereof. That is, this invention is characterized by using a coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0 Herein, the suffix of first "O" in the general formula is 2-(n/2).

### Industrial Applicability

A semiconductor device manufacturing method of this invention can reduce the number of times of CMP and thus is applicable to various semiconductor devices including STI and/or an interlayer insulating film of a multilayer structure.

## Claims

1. A semiconductor device comprising an element isolation region, wherein:
said element isolation region includes an insulating film made of SiO₂ obtained by modifying, by a heat treatment, a coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0).

2. A semiconductor device according to claim 1, wherein said insulating film has a surface flatness of 0.27µm or less in Ra and 2.6µm or less in P-V (peak-to-valley) value.

3. A semiconductor device according to claim 1 or 2, wherein said element isolation region has a depth of 0.26µm or less and a width of 0.22µm or less.

4. A semiconductor device according to any of claims 1 to 3, wherein said insulating film has a flatness of a degree that does not require CMP.

5. A method of manufacturing a semiconductor device comprising an element isolation region, said method comprising:
a step of forming a shallow trench on a semiconductor substrate for forming said element isolation region,
a step of coating a coating film on said semiconductor substrate including said shallow trench, and
a step of modifying said coating film to an element isolation insulator,
wherein said coating film comprises one kind or two or more kinds of compositions expressed by a general formula of ((CH₃)ₙSiO_{2-n/2})ₓ(SiO₂)₁₋ₓ (where n=1 to 3 and 0≤x≤1.0), and
said step of modifying is a step of modifying said coating film to a SiO₂ film by a heat treatment.

6. A method of manufacturing a semiconductor device according to claim 5, wherein said heat treatment is performed at a temperature of 800 to 900ºC.

7. A method of manufacturing a semiconductor device according to claim 5 or 6, said method further comprising a step of causing a surface of said modified SiO₂ film to be equal in height to a surface of said semiconductor substrate without performing CMP.

8. A method of manufacturing a semiconductor device according to claim 7, wherein said step of causing a surface of said modified SiO₂ film to be equal in height to a surface of said semiconductor substrate is an etching step.

9. A method of manufacturing a semiconductor device according to claim 7 or 8, said method further comprising a step of forming an interlayer insulating film, wherein said step of forming an interlayer insulating film comprises a step of coating a coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0) and a step of heat-treating said coating film at a temperature equal to or less than the temperature in said step of modifying.

10. A method of manufacturing a semiconductor device according to claim 9, wherein the temperature equal to or less than the temperature in said step of modifying is a temperature of 600ºC or less.

11. A method of manufacturing a semiconductor device according to claim 9, wherein the temperature equal to or less than the temperature in said step of modifying is a temperature of 400ºC or less.

12. A method of manufacturing a semiconductor device according to any of claims 9 to 11, wherein said step of forming an interlayer insulating film is performed after a step of forming a source region and a drain region in an element forming region of said semiconductor substrate defined by said element isolation region and a step of forming a gate electrode on said element forming region through a gate insulating film and comprises said step of coating a coating film so as to bury said gate electrode.

13. A method of manufacturing a semiconductor device according to claim 12, said method comprising, after said step of forming an interlayer insulating film, a step of forming an electrode reaching at least one of said source region and said drain region, said electrode penetrating said interlayer insulating film.

14. A semiconductor device comprising an interlayer insulating film of a multilayer structure, wherein a lowermost layer of said interlayer insulating film includes a coating film expressed by a general formula of ((CH₃)ₙSiO_{2-n/}2)ₓ(SiO₂)₁₋ₓ (where n=1 to 3 and 0≤x≤1.0).

15. A semiconductor device according to claim 14, wherein an interlayer insulating film as said lowermost layer is an insulating film burying therein a gate electrode of said semiconductor device.

16. A semiconductor device according to claim 14 or 15, wherein an electrode reaching at least one of a source region and a drain region of a semiconductor substrate is provided so as to penetrate said interlayer insulating film as said lowermost layer.

17. A semiconductor device according to any of claims 14 to 16, wherein said interlayer insulating film has a permittivity lower than that of SiO₂.

18. A semiconductor device according to claim 17, wherein the permittivity of said interlayer insulating film is 2.0 to 2.7.

19. A semiconductor device according to claim 17, wherein the permittivity of said interlayer insulating film is 2.2 to 2.5.

20. A semiconductor device according to any of claims 14 to 19, wherein an element isolation region formed in a semiconductor substrate is provided under said interlayer insulating film as said lowermost layer and said element isolation region includes a SiO₂ film formed by modifying a coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0).

21. A semiconductor device manufacturing method comprising a step of forming a plurality of semiconductor elements on a semiconductor substrate, a step of forming a first interlayer insulating film on said semiconductor substrate, a step of forming an electrode layer that penetrates said first interlayer insulating film so as to be electrically connected to at least one of a plurality of regions forming each of said semiconductor elements, and a step of forming a first wiring layer on said first interlayer insulating film so as to be electrically connected to said electrode layer, wherein said step of forming a first interlayer insulating film comprises a step of coating a first coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0) and a step of forming a first insulating film having a predetermined permittivity by heat-treating said first coating film at a predetermined temperature.

22. A semiconductor device manufacturing method according to claim 21, wherein said predetermined temperature is a temperature of 400°C or less.

23. A semiconductor device manufacturing method according to claim 21 or 22, wherein said predetermined permittivity is a permittivity lower than that of SiO₂.

24. A semiconductor device manufacturing method according to claim 21 or 22, wherein said predetermined permittivity is 2.0 to 2.7.

25. A semiconductor device manufacturing method according to claim 21 or 22, wherein said predetermined permittivity is 2.2 to 2.5.

26. A semiconductor device manufacturing method according to any of claims 21 to 25, wherein said plurality of regions forming each of said semiconductor elements include a source region, a drain region, and a gate electrode.

27. A semiconductor device manufacturing method according to any of claims 21 to 26, further comprising a step of forming a second interlayer insulating film on said first interlayer insulating film so as to cover said first wiring layer, a step of forming a first conductor VIA layer that penetrates said second interlayer insulating film so as to be electrically connected to at least part of said first wiring layer, and a step of forming a second wiring layer on said second interlayer insulating film so as to be electrically connected to said first conductor VIA layer.

28. A semiconductor device manufacturing method according to claim 27, wherein said step of forming a second interlayer insulating film comprises a step of coating a second coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0) and a step of forming a second insulating film having a predetermined permittivity by heat-treating said second coating film at a predetermined temperature.

29. A semiconductor device manufacturing method according to any of claims 21 to 28, wherein said step of forming a first wiring layer on said first interlayer insulating film is performed without treating a surface of said first interlayer insulating film by CMP.

30. A semiconductor device manufacturing method according to claim 28, wherein said step of forming a second wiring layer on said second interlayer insulating film is performed without treating a surface of said second interlayer insulating film by CMP.

31. A semiconductor device manufacturing method according to any of claims 21 to 30, wherein a step of forming a shallow trench on said semiconductor substrate, a step of forming an element isolation region in said shallow trench, and a step of forming said plurality of regions forming each of said semiconductor elements are performed before said step of forming a first interlayer insulating film on said semiconductor substrate.

32. A semiconductor device manufacturing method according to claim 31, wherein said step of forming said plurality of regions forming each of said semiconductor elements comprises a step of forming a source region and a drain region in an element forming region of said semiconductor substrate defined by said element isolation region and a step of forming a gate electrode on said element forming region through a gate insulating film.

33. A semiconductor device manufacturing method according to claim 31 or 32, wherein said step of forming an element isolation region comprises a step of coating a third coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0) so as to bury at least said shallow trench and a step of modifying said third coating film to SiO₂.

34. A semiconductor device manufacturing method according to claim 33, wherein said step of modifying to SiO₂ comprises a step of baking and annealing said coated third coating film at 800ºC to 900ºC.

35. A method of manufacturing a semiconductor device comprising an element isolation region and an interlayer insulating film, wherein mutually different heat treatments are applied to the same composition, thereby forming said element isolation region and said interlayer insulating film having mutually different permittivities.

36. A method of manufacturing a semiconductor device according to claim 35, wherein said composition comprises one kind or two or more kinds of compositions expressed by a general formula of ((CH₃)ₙSiO_{2-n/2})ₓ(SiO₂)₁₋ₓ (where n=1 to 3 and 0≤x≤1.0).

37. A method of manufacturing a semiconductor device according to claim 36, wherein formation of said element isolation region and said interlayer insulating film includes no CMP process.

38. A semiconductor device comprising a semiconductor substrate, a semiconductor element having a plurality of regions and formed on said semiconductor substrate, a first interlayer insulating film formed on said semiconductor substrate, an electrode layer penetrating said first interlayer insulating film so as to be electrically connected to at least one of said plurality of regions, and a first wiring layer provided on said first interlayer insulating film so as to be electrically connected to said electrode layer, wherein said first interlayer insulating film includes a first coating film comprising one kind or two or more kinds of compositions expressed by a general formula of ((CH₃)ₙSiO_{2-n/2})ₓ(SiO₂)₁₋ₓ (where n=1 to 3 and 0≤x≤1.0).

39. A semiconductor device according to claim 38, wherein said semiconductor element includes a gate electrode formed on said semiconductor substrate through a gate insulating film and said first interlayer insulating film buries said gate electrode therein.

40. A semiconductor device according to claim 38 or 39, wherein said plurality of regions include a source region and a drain region and said electrode layer is electrically connected to at least one of said source region and said drain region.

41. A semiconductor device according to any of claims 38 to 40, wherein said interlayer insulating film has a permittivity lower than that of SiO₂.

42. A semiconductor device according to claim 41, wherein the permittivity of said interlayer insulating film is 2.0 to 2.7.

43. A semiconductor device according to claim 41, wherein the permittivity of said interlayer insulating film is 2.2 to 2.5.
